# EUROPEAN PATENT APPLICATION

(11) **EP 3 503 213 A1**
(43) Date of publication of application: **26.06.2019**
(21) Application number: 17209641.4
(22) Date of filing: 21.12.2017
(51) Int. Cl.: H01L 31/048, H01L 31/042, H02S 20/10, H02S 20/21

(54) **PHOTOVOLTAIC ROADWAY ASSEMBLY**

(71) Applicant: Nederlandse Organisatie voor toegepast- natuurwetenschappelijk onderzoek TNO, 2595 DA 's-Gravenhage (NL)
(72) Inventor: Fischer, Hartmut Rudolf, 2595 DA 's-Gravenhage (NL); Klerks, Stan Anton, 2595 DA 's-Gravenhage (NL); Turkenburg, Daniël Hendrik, 2595 DA 's-Gravenhage (NL)
(74) Representative: V.O.

(57) **Abstract**

The invention is directed to a photovoltaic roadway assembly, to the use of a primer layer comprising thermally reversible crosslinks, to a method of assembling a photovoltaic roadway assembly, and to a method of replacing at least part of a top layer in a photovoltaic roadway.

The photovoltaic roadway assembly of the invention comprises a support, one or more photovoltaic modules assembled to said support, and a top layer, said top layer being attached to said one or more photovoltaic modules with a primer layer, wherein said primer layer comprises at least one organic polymer with thermally reversible crosslinks.

## Description

The invention is directed to a photovoltaic roadway assembly, to the use of a primer layer comprising thermally reversible crosslinks, to a method of assembling a photovoltaic roadway assembly, and to a method of replacing at least part of a top layer in a photovoltaic roadway.

In recent years, photovoltaic trafficable surfaces have emerged as a solution to increase the amount of energy harvested from the sun.

Existing photovoltaic roadway systems typically have the following components: a support, a photovoltaic module, a top layer, and an electrical system. The support is typically a plate or a block made from a material having high stiffness (such as concrete), which supports functions as a base for the other components. The photovoltaic module comprises individual photovoltaic cells that are typically interconnected into strings, which convert sunlight into electricity. The photovoltaic cells are laminated between layers of, for instance, plastic, glass and/or metal for protection against external mechanical and climatological influences. The top layer (typically an anti-slip layer) is typically a rough, transparent layer that allows the passage of sunlight and at the same time ensures a safe road surface for road users. The electrical system ensures transport of the produced electricity to the desired locations, such as to the electricity grid.

One photovoltaic trafficable surface, known as SolaRoad®, is located in the town of Krommenie in the Netherlands. This photovoltaic trafficable surface comprises a top layer of tempered glass of about 1 cm thick with underneath crystalline silicon solar cells. The SolaRoad® system is prefabricated as a whole as 2.5 by 3.5 metre concrete modules comprising the polycrystalline silicon solar cells. These modules are transported to the toad site and placed as such on the desired location.

Another type of photovoltaic trafficable surface developed by Colas together with Commissariat à l'énergie atomique et aux énergies alternatives is known as Wattway® and is, for instance, described in WO-A-2014/125415. In this system photovoltaic modules laminated on plastic (fibre reinforced polyester) flexible plates are glued on the existing paving and subsequently a continuous surfacing layer is applied which has texturing elements that provide roughness.

An integral concept of a traffic element with integrated photovoltaic module is described in WO-A-2005/086979. The integrated photovoltaic solar power system comprises a roadway panel with a solar energy collector and a layer of translucent and protective material, and an electrical conductor.

Different components in such a photovoltaic roadway system have a different lifespan. In particular, the photovoltaic modules and the top layer degrade at different rates. The lifespan of a photovoltaic module can be around 25 years, whereas road surfaces (and top layers of roadways) typically have lower lifespan of about 10 to 15 years. The top layer is prone to wear, which may involve loss of anti-slip texture and/or loss of transparency. In particular loss of transparency may lead to lower production of electricity. Due to the internal structure and nature of the used materials (thermosets), a complete replacement of the top layer is nearly impossible without destructive measures. Only mechanical removal is a suitable way to proceed in such cases. There is a high probability during such mechanical removal that the underlying photovoltaic modules are damaged. Also, there is a desire to be able to decompose the various materials in the best way possible for optimal recycling. A clean (complete) removal of the top layer is desired in order to be able to achieve the highest transparency (and yield) after reapplication of top layers. It is further desirable to be able to repair a local spot (partial removal) and a complete overhaul of the top layer after its expected service life of about 10-15 years.

Objective of the invention is to address one or more drawbacks observed in the prior art.

Further objective of the invention is to provide a solution that allows separately removing and/or replacing a top layer in a photovoltaic roadway assembly.

The inventors found that this objective can, at least in part, be met by a photovoltaic roadway assembly wherein the top layer is attached to the one or more photovoltaic modules by means of a specific primer layer.

Accordingly, in a first aspect the invention is directed to a photovoltaic roadway assembly comprising a support, one or more photovoltaic modules assembled to said support, and a top layer, said top layer being attached to said one or more photovoltaic modules with a primer layer, wherein said primer layer comprises at least one organic polymer with thermally reversible crosslinks.

Advantageously, the invention provides a photovoltaic roadway assembly that allows to separately remove the top layer. By heating the primer layer, the thermally reversible crosslinks at least partly cleave. As a result, the adhesive strength of the primer layer is lost to such an extent that the top layer may be removed and/or replaced. The invention advantageously allows to take off the entire top layer as a solid (possibly broken layer). Upon applying a fresh (part of a) top layer, the primer layer can be cooled again, thereby reforming thermally reversible crosslinks and, consequently, gaining adhesive strength. In accordance with the invention, it is advantageously not required to apply new primer, when replacing (part of) the top layer. The existing primer layer can be reused, simply by cooling it once the top layer has been placed.

Moreover, because the primer layer becomes low-viscous upon heating, the various materials can be readily decomposed for optimal recycling.

The thermally reversible crosslinks are preferably based, at least in part, on a reversible Diels-Alder reaction. Such reactions between a diene and a dienophile are known. The rate of reaction between a diene and a dienophile is determined by the individual components and the substituents on them. Typically, upon heating the equilibrium between adduct and dienophile/diene shifts to increase the amount of the diene and dienophile. This is advantageous, since it leads to the cleavage of crosslinks at elevated temperatures. whereas at lower temperatures the crosslinks reform. Thus, at relatively lower temperatures (typically room temperature), the primer exists as a non-deformable crosslinked polymer network having high viscosity and high mechanical strength. Upon elevating the temperature, at least part of the thermally reversible crosslinks are cleaved, thereby lowering the viscosity and mechanical strength of the primer. At the same time the adhesive strength of the primer layer (and thus between the photovoltaic module and the top layer) is lowered.

Preferably, the thermally reversible crosslinks are based on a reversible Diels-Alder reaction that comprises a reaction between a conjugated diene and a dienophile, such as between a furane group and a maleimide group. The furane groups may be present, e.g., in the form of furfuryl groups, furfuryl amine groups, furfuryl alcohol groups, and the like. An advantageous organic polymer that may be used in accordance with the present invention is a furfuryl glycidyl ether. Other possible conjugated dienes includes pentadiene derivatives, anthracenes, and the like.

Preferably, the organic polymer comprises an amount of diene groups of 0.1-40 % by total weight of the polymer, such as 0.5-35 %, or 1 -30 %.

The maleimide groups may be present in the organic polymer, but are preferably provided in the form of a bismaleimide crosslinker. Preferably, the bismaleimide crosslinker comprises one or more selected from the group consisting of *N*,*N*'-1,3-phenylene bismaleimide, *N*,*N*'-ethylene bismaleimide, *N*,*N*'-hexamethylene-bismaleimide, *N*,*N*'-(4-methyl-meta-phenylene)-bismaleimide, 1,1'-(methylenedi-4,1-phenylene)-bismaleimide, *N*,*N*-4,4-(diphenylmethane)bismaleimide, polyphenylmethanebismaleimide, *N*,*N*'-*meta*-phenylene-bismaleimide, *N*,*N*'-*para*-phenylene-bismaleimide, *N,N*'*-*4,4'-biphenylene-bismaleimide*, N*,*N*'-4,4'-(diphenyl ether)-bismaleimide, *N*,*N*'-4,4'-(diphenyl sulphide)-bismaleimide, *N*,*N*'-*meta*-phenylenebismaleimide, *N*,*N*'-4,4'-diphenylsulphone-bismaleimide, *N*,*N*'-4,4'-dicyclohexylmethane-bismaleimide, *N*,*N*'*-*α*,*α*'*-4,4*'-*dimethylenecyclohexane-bismaleimide*, N*,*N*'-*meta*-xylylene-bismaleimide, *N*,*N*'-*para*-xylylene-bismaleimide, *N*,*N*'-4,4'-(1,1-diphenylcyclohexane)-bismaleimide, *N*,*N*'-4,4'-diphenylmethane-bischloromaleimide, *N*,*N*'-4,4'-(1,1-diphenylpropane)-bismaleimide, *N*,*N*'-4,4'-(1,1,1-triphenylethane)-bismaleimide, *N*,*N*'-4,4'-triphenylmethane-bismaleimide, *N*,*N*'-3,5-triazole-1,2,4-bismaleimide, *N*,*N*'-dodecamethylene-bismaleimide, *N*,*N*'-(2,2,4-trimethylhexamethylene)-bismaleimide, *N*,*N*'-4,4'-benzophenone-bismaleimide, *N*,*N*'-pyridine-2,6-diyl-bismaleimide, *N*,*N*'-naphthylene-1,5-bismaleimide, *N*,*N*'-cyclohexylene-1,4-bismaleimide, *N*,*N*'-5-methylphenylene-1,3-bismaleimide, and *N*,*N*'-5-methoxyphenylene-1,3-bismaleimide.

The molar ratio between the conjugated diene and the dienophile, and particularly between maleimide groups and furane groups, may suitably be in the range of 0.6-1.2, preferably in the range of 0.7-1.1, more preferably in the range of 0.8-1.0. A molar ratio between the conjugated diene and the dienophile of more than 1.2, results in large quantities of unreacted bismaleimide, which are susceptible to side reactions. When the molar ratio between the conjugated diene and the dienophile is less than 0.6 then the mechanical strength of the crosslinked network decreases.

The at least one organic polymer may suitably comprise one or more selected from an epoxy-based polymer, a poly(meth)acrylate, a polyester or vinyl ester, or a polyurethane. Vinyl esters and epoxy-based polymers are preferred as these polymers are less sensitive to degradation by ultraviolet radiation. In particular epoxy-based polymers are suitably, because such polymers in general give rise to good adhesive strength and hardly give rise to foaming. These polymers further have the advantage of being hardly coloured and relatively transparent. Moreover, a wide variety of epoxy-based polymers is readily available for relatively low cost, they have excellent strength, and are easy to handle. It is, of course, also possible to use a polymer blend.

The primer preferably has thermosetting properties at room temperature. This is meant to indicate that at room temperature, the polymer in the primer is in a cured crosslinked form. it is not meant to indicate that the primer remains solid upon heating. To the contrary, due to the thermally reversible crosslinks in the at least one organic polymer the polymer becomes liquid or flowable at elevated temperatures.

Primer layers that have thermosetting properties at room temperature further typically have properties that are comparable to the properties of conventional (thermoset) crosslinked materials (such as solvent resistance, hardness, stiffness, toughness, *etc*.), but advantageously are thermoplastically processable as well. Moreover, these composite materials remain thermoplastically processable for many repetitions.

The preferred amount of thermally reversible crosslinks in the primer layer is 0.1-50 % by total weight of the primer layer, such as 1-40 %, or 2-35 %.

The primer layer may further comprise one or more additives selected from surfactants, defoamers and modifiers. Such additives may suitably be present in an amount of 1-50 % by total weight of the primer layer, such as 2-20 %.

The primer layer preferably comprises 50-100 % of organic polymer with thermally reversible crosslinks by total weight of the primer layer, such as 80-100 %, 85-99 %, or 90-98 %.

The primer layer may have a layer thickness in the range of 0.5-200 µm, such as in the range of 1-50 µm.

The top layer in the photovoltaic roadway assembly of the invention is typically an anti-skid layer or anti-slip layer. Such an anti-skid or anti-slip layer can be used to increase the surface roughness and wear resistance (resistance to scratching *etc*.). The top layer may alternatively or additionally be a protective layer to mechanically protect the underlying photovoltaic modules.

Examples of suitable materials that may be comprised in the top layer include clear plastic, polytetrafluoroethylene, acrylic, polycarbonate, abrasion resistant versions of the above materials (*i*.*e*. those materials coated with an anti-scratch laminate), Diamonex® coated polycarbonate, fiberglass in epoxy on polycarbonate, tempered glass, annealed glass, and glass balls in epoxy on annealed glass. The most preferred material is polycarbonate-backed acrylic. In case the top layer serves as anti-skid layer, it should provide sufficient friction to traffic passing on the roadway so as to prevent slippage of vehicles and/or people. Accordingly, the material of the top layer should provide sufficient friction, either by the nature of its composition or through subsequent treatment.

In an embodiment, the top layer comprises surface frictional elements formed into its upper (sun-facing) surface. Frictional elements can be particularly useful on surfaces that are very strong, abrasive resistant and light-permeable, but either do not by themselves provide enough traction for traffic to pass thereon or for which additional traction is desired.

Such frictional elements can be elements that project upwards (*viz.* to the sun), or indentations or grooves that are formed into the top layer. Alternatively, frictional elements can be external materials that are set onto or within the upper surface of the top layer. Frictional elements can also have any cross-sectional shapes, so long ass they are shape so as to provide sufficient friction to the top layer, while not impeding the transmission of light there through to the photovoltaic modules. Frictional elements in the top layer may be in any desired direction, pattern or shape, such as straight lines, curved lines, cross lines, circles or any other geometric shapes and patterns, long or short, so as to perform the desired function.

Typically, the top layer may have a layer thickness in the range of 0.5-10 mm, such as in the range of 2-5 mm.

Both the primer layer and top layer are preferably transparent. The term "transparent" as used in this document is meant to refer to layers and materials which allow at least 75 % of visible and non-visible solar radiation, such as 80-100 % of this radiation to be transmitted, in particular to the underlying photovoltaic modules.

The support is preferably made of a material having a high stiffness, such as concrete, asphalt, or brick. Preferably, the support is made of concrete. The support is suitably a construction base that serves to absorb most of the weight load of the traffic. Typically, for trafficable surfaces the weight load is in the range of 0.5-1.5 MPa.

Each photovoltaic modules typically comprises a photovoltaic panel with a plurality of photovoltaic cells, being polycrystalline silicon solar cells or thin film solar cells, *e.g.* amorphous silicon (a-Si), cadmium telluride (CdTe), copper indium gallium selenide (CIGS) or organic photovoltaics (OPV). Polycrystalline silicon solar cells commonly have a dimension of 156 × 156 mm, and a panel commonly has 6 × 10 cells and has a dimension of about 1000 × 1600 mm. Thin film solar cells and panels on the other hand may vary in sizes and dimensions. Optionally, a photovoltaic modules may be provided with one or more layers of separation foil (also commonly known as encapsulant) and/or top foil so as to prepare a more robust photovoltaic module. The separation foil or encapsulant may be used to encapsulate the solar cells and bond the materials (back sheet, solar cell, front sheet) together. It may suitably comprise ethylene-vinyl-acetate, polyvinylbutyral and/or polyolefin. The top foil may suitably comprise ethylene-tetrafluoroethylene, polyethylene terephthalate, polycarbonate and/or glass.

The photovoltaic modules may further comprise one or more protective layers that serve as mechanical support and protection. Preferably, the protective layer is a transparent layer and may comprise a thin, coated flexible glass layer. Any suitable glass material may be used, such as soda lime glass, borosilicate glass, low alkali soda lime glass, *etc.* The glass layer may be sufficiently thin, such as having a thickness of 50-500 µm, to provide flexibility. Also other materials than glass may be used. For examples, commercial polymers protective layers are available, such as 3M™ Ultra Barrier Solar Film 510-F. Protective layers may also be created through atomic layer deposition processes.

In some cases, the protective barrier can also include a weatherable top sheet on the sun facing side, for protecting the cell(s) from moisture. The top sheet may be a fluoropolymer layer, such as an ethylene-tetrafluoroethylene copolymer (ETFE) top layer or a fluorinated ethylene propylene (FEP) top sheet.

In a further aspect, the invention is directed to the use of a primer layer comprising thermally reversible crosslinks in a trafficable surface, an exterior wall of a building, a roof, a baffle board. Preferably, the invention relates to the use of a primer layer comprising thermally reversible crosslinks in a roadway, more preferably in a photovoltaic roadway assembly.

The primer layer of this aspect of the invention is preferably a primer layer as described herein.

In yet a further aspect, the invention is directed to a method of assembling a photovoltaic roadway assembly, comprising assembling one or more photovoltaic modules onto a support, and attaching a top layer onto said one or more photovoltaic modules with a primer layer, wherein said primer layer comprises thermally reversible crosslinks.

The step of assembling one or more photovoltaic modules onto a support may be performed on site, *i.e.* where the roadway is constructed, but may advantageously also be performed off site, such as in a factory.

After assembly of the one or more photovoltaic modules, typically the primer layer is applied onto the photovoltaic modules. Suitably, this may comprise applying a layer of non-crosslinked organic polymer (preferably a polymer having furane groups) and thereafter adding a crosslinking agent (preferably a maleimide crosslinker). Alternatively, a polymer with thermally reversible crosslinks can be applied at elevated temperature where at least part of the thermally reversible crosslinks are cleaved. Application of the primer layer is preferably performed at elevated temperature where at least part of the thermally reversible crosslinks are (still) debonded. Such temperatures depend on the structure of the organic polymer and may suitably be 5-50 K above the T_{g} of the organic polymer. For example, the temperature of the primer layer during application can be in the range of 75-120 °C, such as in the range of 85-110 °C. Also attachment of the top layer is preferably performed at such elevated temperatures in order to ensure optimal adhesion between the photovoltaic module and the top layer. After having applied the top layer, the temperature is left to cool such that thermally reversible crosslinks form, or reform. Cooling may either be passive or active. Suitably, the temperature of the primer layer is cooled to a temperature in the range of 10-50 °C, preferably in the range of 15-30 °C.

The primer layer in this aspect of the invention is preferably a primer layer as described herein.

In yet a further aspect, the invention is directed to a method of replacing at least part of a top layer in a photovoltaic roadway assembly of the invention, comprising heating the primer layer to a temperature at which at least part of the thermally reversible crosslinks cleave and thereby debonding at least part of the top layer, removing a debonded part of the top layer thereby creating an exposed location, and bonding a fresh top layer to the exposed location by cooling the primer layer to temperature at which thermally reversible crosslinks reform.

The temperature to which the primer layer is heated in order to cleave at least part of the thermally reversible crosslinks depends on the structure of the organic polymer and may suitably be 5-50 K above the T_{g} of the organic polymer. The temperature can, for example, be in the range of 75-120 °C, preferably in the range of 85-110 °C. Heating may typically be performed for a time period of 120-600 s, such as 180-300 s.

Heating may be realised in several ways. For example, heat can be applied through a radiant heat source placed above the surface of the roadway assembly and the surface can be heated in a controlled process until the desired temperature, at which the thermally reversible crosslinks cleave, is reached. This can be done very locally, or on a larger surface area, depending on the size of the reparation. It is also possible to generate heat by induction heating of a metal part which may be part of the photovoltaic module. Metal sheets can act as a part of the photovoltaic modules. Also this can be done very locally, or on a larger surface area, depending on the size of the reparation. Another way of generating heat is by reversing the current in the photovoltaic cells. When electric power is imposed on a module it can be brought to a mode where it converts electricity into heat. This can be suitably applied to heat the surface of a module, and accordingly the primer layer.

The invention can be further illustrated by the following exemplary description of the production of photovoltaic roadway assembly.

First, a photovoltaic module is made. Photovoltaic material (C-Si, thin film *etc*.) is produced. This can be in discrete sections (C-Si, thin film) or be a roll of material (flexible thin film). The first is connected in series via bus-bars or conducting foils. The last may be interconnected through a process called 'back end processing' where a P1-P2-P3 scribe put sections of the foil in series. Bypass diodes may be introduced to improve shading tolerance and to protect the cells. This assembly is laminated into a module with the help of encapsulants (ethylene vinyl acetate (EVA), polyoxyethylene (POE), polyvinylbutyral (PVB), silicon) and materials preventing moisture, oxygen, CO₂, *etc.* ingress towards the cell material. These materials can be metals, glass, (coated) foils *etc.* Electric connections to the exterior of the module are made to be able to connect these.

Then, the following steps are made. These steps can be performed in different order.
- Application of primer layer with reversible properties on the front 'sunny side' of the photovoltaic module. This can be done through rolling, spraying, brushing. Application and/or curing of primer layer may take place at elevated temperatures.
- Application of anti-skid layer on top of the primer layer. This can be done through rolling, spraying, brushing, casting. This can also be done in multiple steps with curing in between the steps. Application and/or curing of anti-skid layer may take place at elevated temperatures. But below temperatures when the reversibility is triggered. Preferably this is done in a factory, but on site production is also an option.
- Application of mounting construction to the photovoltaic module with or without the primer layer and/or anti-skid layer. This mounting construction can be a rigid construction such as a metal or polymer frame but can also be flexible material such as a foil, metal sheet, woven (fibrous) material. One or more photovoltaic modules may be combined on one mounting construction. This application is typically done with adhesives. This mounting construction can contain electrical interconnections, connecting *e.g.* the modules to an electronic device, which might be integrated in the mounting construction.
- Application of the construction described above (module, mounting construction) to a rigid material, being able to transfer the loads from the traffic to the earth below with minimal deformation to ensure a safe road and a robust construction. This can be concrete, asphalt, *etc.* In the case of concrete this can be done by mechanical fixing and/or bonding (via adhesives) in a factory where elements are produced, in the case of asphalt bonding (via adhesives) on site is proposed.
- If prefabricated: the elements are placed on a foundation.
- Electrical connections are made, connecting the modules to the grid or to 'appliances' through electrical components such as DC-DC inverters, DC-AC inverters, bus-bars, diodes, circuit breakers, these components can be placed in the modules, in the mounting system, in a separate construction such as a cable duct next to the road or in the earth next to the road.

The invention has been described by reference to various embodiments, and methods. The skilled person understands that features of various embodiments and methods can be combined with each other.

All references cited herein are hereby completely incorporated by reference to the same extent as if each reference were individually and specifically indicated to be incorporated by reference and were set forth in its entirety herein.

The use of the terms "a" and "an" and "the" and similar referents in the context of describing the invention (especially in the context of the claims) are to be construed to cover both the singular and the plural, unless otherwise indicated herein or clearly contradicted by context. The terms "comprising", "having", "including" and "containing" are to be construed as open-ended terms (*i*.*e*., meaning "including, but not limited to") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. The use of any and all examples, or exemplary language (*e.g.,* "such as") provided herein, is intended merely to better illuminate the invention and does not pose a limitation on the scope of the invention unless otherwise claimed. No language in the specification should be construed as indicating any non-claimed element as essential to the practice of the invention. For the purpose of the description and of the appended claims, except where otherwise indicated, all numbers expressing amounts, quantities, percentages, and so forth, are to be understood as being modified in all instances by the term "about". Also, all ranges include any combination of the maximum and minimum points disclosed and include any intermediate ranges therein, which may or may not be specifically enumerated herein.

Preferred embodiments of this invention are described herein. Variation of those preferred embodiments may become apparent to those of ordinary skill in the art upon reading the foregoing description. The inventors expect skilled artisans to employ such variations as appropriate, and the inventors intend for the invention to be practiced otherwise than as specifically described herein. Accordingly, this invention includes all modifications and equivalents of the subject-matter recited in the claims appended hereto as permitted by applicable law. Moreover, any combination of the above-described elements in all possible variations thereof is encompassed by the invention unless otherwise indicated herein or otherwise clearly contradicted by context. The claims are to be construed to include alternative embodiments to the extent permitted by the prior art.

For the purpose of clarity and a concise description features are described herein as part of the same or separate embodiments, however, it will be appreciated that the scope of the invention may include embodiments having combinations of all or some of the features described.

The invention will now be further illustrated by means of the following example, which is not intended to limit the scope in any manner.

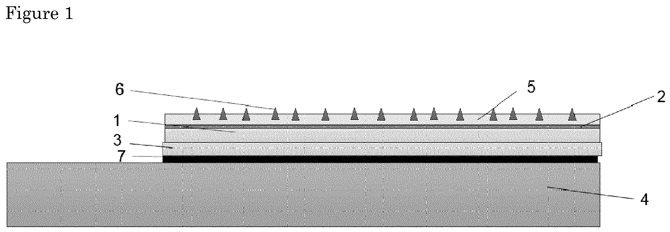

A schematic example of a photovoltaic roadway assembly of the invention is shown in figure 1. The embodiment in this figure comprises photovoltaic module 1 that is attached onto a support 4 (such as a concrete support) using an optional underlying carrier layer 3 and an optional adhesion layer 7. On top of the photovoltaic module is a top layer 5 that is attached to the photovoltaic module 1 with a primer layer 2. In accordance with the invention, primer layer 2 comprises at least one organic polymer with thermally reversible crosslinks. The top layer 5 in the example shown in figure 1 is provided with surface frictional elements 6 in its upper (sun-facing) surface.

## Claims

1. Photovoltaic roadway assembly comprising a support, one or more photovoltaic modules assembled to said support, and a top layer, said top layer being attached to said one or more photovoltaic modules with a primer layer, wherein said primer layer comprises at least one organic polymer with thermally reversible crosslinks.

2. Photovoltaic roadway assembly according to claim 1, wherein the thermally reversible crosslinks are based on a reversible Diels-Alder reaction.

3. Photovoltaic roadway assembly according to claim 2, wherein the reversible Diels-Alder reaction comprises a reaction between furane groups and maleimide groups.

4. Photovoltaic roadway assembly according to any one of claims 1-3, wherein the at least one organic polymer comprises one or more selected from an epoxy, an acrylate, or a polyester-urethane.

5. Photovoltaic roadway assembly according to claim 3 or 4, wherein the maleimide groups are provided in the form of a bismaleimide crosslinker, wherein said bismaleimide crosslinker preferably comprises one or more selected from the group consisting of *N*,*N*'-1,3-phenylene bismaleimide, *N*,*N*'-ethylene bismaleimide, *N*,*N*'-(4-methyl-*meta*-phenylene)-bismaleimide, 1,1'-(methylenedi-4,1-phenylene)-bismaleimide, *N*,*N*'-4,4-(diphenylmethane)bismaleimide, polyphenylmethanebismaleimide, *N*,*N*'-*meta*-phenylene-bismaleimide, *N*,*N*'-*para*-phenylene-bismaleimide, *N*,*N*'-4,4'-biphenylene-bismaleimide, *N*,*N*'-4,4'-(diphenyl ether)-bismaleimide, *N*,*N*'-4,4'-(diphenyl sulphide)-bismaleimide, *N*,*N*'-*meta*-phenylenebismaleimide, *N*,*N*'-4,4'-diphenylsulphone-bismaleimide, *N*,*N*'-4,4'-dicyclohexylmethane-bismaleimide, *N*,*N*'-α,α'-4,4'-dimethylenecyclohexane-bismaleimide, *N*,*N*'-*meta*-xylylene-bismaleimide, *N*,*N*'-*para*-xylylene-bismaleimide, *N*,*N*'-4,4'-(1,1-diphenylcyclohexane)-bismaleimide, *N*,*N*'-4,4'-diphenylmethane-bischloromaleimide, *N*,*N*'-4,4'-(1,1-diphenylpropane)-bismaleimide, *N*,*N*'-4,4'-(1,1,1-triphenylethane)-bismaleimide, *N*,*N*'-4,4'-triphenylmethane-bismaleimide, *N*,*N*'-3,5-triazole-1,2,4-bismaleimide, *N*,*N*'-dodecamethylene-bismaleimide, *N*,*N*'-(2,2,4-trimethylhexamethylene)-bismaleimide, *N*,*N*'-4,4'-benzophenone-bismaleimide, *N*,*N*'-pyridine-2,6-diy1-bismaleimide, *N*,*N*'-naphthylene-1,5-bismaleimide, *N*,*N*'-cyclohexylene-1,4-bismaleimide, *N*,*N*'-5-methylphenylene-1,3-bismaleimide, and *N*,*N*'-5-methoxyphenylene-1,3-bismaleimide

6. Photovoltaic roadway assembly according to any one of claims 3-5, wherein the molar ratio between maleimide groups and furane groups is in the range of 0.6-1.2, preferably in the range of 0.7-1.1, more preferably in the range of 0.8-1.0.

7. Photovoltaic roadway assembly according to any one of claims 1-6, wherein said top layer is an anti-skid layer.

8. Use of a primer layer comprising thermally reversible crosslinks in a roadway assembly, preferably a photovoltaic roadway assembly.

9. Use of a primer layer according to claim 8, wherein said primer layer is a primer layer as defined in any one of claims 1-6.

10. Method of assembling a photovoltaic roadway assembly, comprising assembling one or more photovoltaic modules onto a support, and attaching a top layer onto said one or more photovoltaic modules with a primer layer, wherein said primer layer comprises thermally reversible crosslinks.

11. Method according to claim 10, wherein said primer layer is a primer layer as defined in any one of claims 1-6.

12. Method according to claims 10 or 11, wherein the primer layer is applied by applying a non-crosslinked organic polymer, and thereafter adding a crosslinking agent.

13. Method of replacing at least part of a top layer in a photovoltaic roadway assembly according to any one of claims 1-7, comprising heating the primer layer to a temperature at which at least part of the thermally reversible crosslinks cleave and thereby debonding at least part of the top layer, removing a debonded part of the top layer thereby creating an exposed location, and bonding a fresh top layer to the exposed location by cooling the primer layer to temperature at which thermally reversible crosslinks reform.

14. Method according to claim 13, wherein heating the primer layer to a temperature at which at least part of the thermally reversible crosslinks cleave comprises heating to a temperature in the range of 75-120 °C, preferably in the range of 85-110 °C.

15. Method according to claim 13 or 14, wherein said heating comprises
i) induction heating of a metal part that is comprised in one or more of the photovoltaic modules; and/or
ii) reversing the current in the photovoltaic modules.
